# EUROPÄISCHE PATENTANMELDUNG

(11) **EP 0 889 506 A2**
(43) Veröffentlichungstag der Anmeldung: **07.01.1999**
(21) Anmeldenummer: 98112292.2
(22) Anmeldetag: 02.07.1998
(51) Int. Cl.: H01L 21/311, C23F 1/00

(54) **Strukturierungsverfahren**

(30) Priorität: 03.07.1997 DE 19728472
(71) Anmelder: SIEMENS AKTIENGESELLSCHAFT, 80333 München (DE)
(72) Erfinder: Engelhardt, Manfred, Dr., 83620 Feldkirchen-Westerham (DE); Schwarzl, Siegfried, Dr., 85579 Neubiberg (DE)

(57) **Zusammenfassung**

Erfindungsgemäß wird ein Verfahren zur Strukturierung zumindest einer zu strukturierenden Schicht, bereitgestellt, das die folgenden Schritte umfaßt: die zu strukturierende Schicht wird auf einer Unterlage bereitgestellt, eine Maske wird auf der zu strukturierenden Schicht bereitgestellt, die zu strukturierende Schicht wird trockengeätzt, wobei zumindest ein reaktiver Stoff vorgesehen ist. Das erfindungsgemäße Verfahren ist dadurch gekennzeichnet, daß während der Trockenätzung der reaktive Stoff und das Material der Maske und/oder der Unterlage an der Oberfläche der Maske und/oder der Unterlage zu einer nicht flüchtigen Verbindung reagieren.

## Beschreibung

Die vorliegende Erfindung betrifft ein Strukturierungsverfahren, insbesondere ein Verfahren zur Strukturierung von plasmachemisch nur schwer oder nicht ätzbaren Schichten wie beispielsweise Schichten aus Edelmetallen, ferroelektrischen Materialien sowie dielektrischen Materialien mit hoher Permittivität.

Bei der Entwicklung von hochintegrierten Speicherbausteinen, wie z.B. DRAMs bzw. FRAMs sollte die Zellkapazität bei der fortschreitenden Miniaturisierung beibehalten oder sogar noch verbessert werden. Zur erreichung dieses Ziels werden immer dünnere dielektrische Schichten und gefaltete Kondensatorelektroden (Trench-Zelle, Stack-Zelle) verwendet. In letzter Zeit werden anstatt des herkömmlichen Siliziumoxids neue Materialien, insbesondere Paraelektrika und Ferroelektrika, zwischen den Kondensatorelektroden einer Speicherzelle verwendet. Beispielsweise kommen Bariumstrontiumtitanat (BST, (Ba,Sr)TiO₃), Bleizirkontitanat (PZT, Pb(Zr,Ti)O₃) bzw. Lanthan-dotiertes Bleizirkontitanat oder Strontiumwismuttantalat (SBT, SrBi₂Ta₂O₉) für die Kondensatoren der Speicherzellen bei DRAMs bzw. FRAMs zum Einsatz.

Dabei werden diese Materialien üblicherweise auf bereits vorhandenen Elektroden (Bodenelektroden) abgeschieden. Die Prozessierung erfolgt unter hohen Temperaturen, so daß die Materialien, aus denen normalerweise die Kondensatorelektroden bestehen, so z.B. dotiertes Polysilizium, leicht oxidiert werden und ihre elektrisch leitenden Eigenschaften verlieren, was zum Ausfall der Speicherzelle führen würde.

Wegen ihrer guten Oxidationsbeständigkeit und/oder der Ausbildung elektrisch leitfähiger Oxide gelten 4d und 5d Übergangsmetalle, insbesondere Platinmetalle (Ru, Rh, Pd, Os, Ir, Pt) und insbesondere Platin selbst, sowie Rhenium als aussichtsreiche Kandidaten, die dotiertes Polysilizium als Elektrodenmaterial in den obengenannten Speicherzellen ersetzen könnten.

Die fortschreitende Miniaturisierung der Bauelemente hat ebenfalls zur Folge, daß Ersatzmaterialien für das heute für die Leiterbahnen verwendete Aluminium erforderlich werden. Dabei sollte das Ersatzmaterial einen geringeren spezifischen Widerstand und eine geringere Elektromigration als Aluminium aufweisen. Als aussichtsreichster Kandidat gilt dabei Kupfer.

Weiterhin erfordert die Entwicklung magnetischer 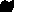 Random Access Memories" (MRAMs) die Integration magnetischer Schichten (z.B. Fe, Co, Ni oder Permalloy) in mikroelektronische Schaltungen.

Um aus den genannten, bisher in der Halbleitertechnologie noch nicht verbreiteten Materialien eine integrierte Schaltung aufbauen zu können, müssen dünne Schichten dieser Materialien strukturiert werden.

Die Strukturierung der bisher verwendeten Materialien erfolgt in der Regel durch sogenannte plasmaunterstützte anisotrope Ätzverfahren. Dabei werden üblicherweise physikalischchemische Verfahren angewandt, bei denen Gasgemische aus einem oder mehreren reaktiven Gasen, wie z.B. Sauerstoff, Chlor, Brom, Chlorwasserstoff, Bromwasserstoff bzw. halogenierten Kohlenwasserstoffen und aus Edelgasen (z.B. Ar, He) verwendet werden. Diese Gasgemische werden in der Regel in einem elektromagnetischen Wechselfeld bei geringen Drücken angeregt.

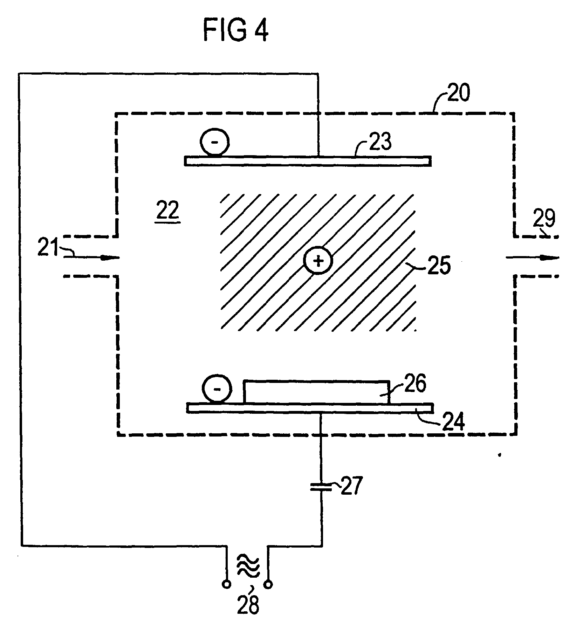

Fig. 4 zeigt die prinzipielle Arbeitsweise einer Ätzkammer, dargestellt am Beispiel eines Parallelplattenreaktors 20. Das Gasgemisch, z.B. Ar und Cl₂, wird über den Gaseinlass 21 der eigentlichen Reaktorkammer 22 zugeführt und durch den Gasauslass 29 wieder abgepumpt. Die untere Platte 24 des Parallelplattenreaktors ist über eine Kapazität 27 mit einer Hochfrequenzquelle 28 verbunden und dient als Substrathalter. Durch das Anlegen eines hochfrequenten elektrischen Wechselfeldes an die obere und die untere Platte 23, 24 des Parallelplattenreaktors wird das Gasgemisch in ein Plasma 25 überführt. Da die Beweglichkeit der Elektronen größer als die der Gaskationen ist, laden sich obere und die untere Platte 23, 24 gegenüber dem Plasma 25 negativ auf. Daher üben beide Platten 23, 24 auf die positiv geladenen Gaskationen eine hohe Anziehungskraft aus, so daß sie einem permanenten Bombardement durch diese Ionen, z.B. Ar⁺ ausgesetzt sind. Da der Gasdruck zudem niedrig gehalten wird, typischerweise 0.1 - 10 Pa, findet nur eine geringfügige Streuung der Ionen untereinander und an den Neutralteilchen statt, und die Ionen treffen nahezu senkrecht auf die Oberfläche eines Substrats 26, das auf der unteren Platte 24 des Parallelplattenreaktors gehalten ist. Dies erlaubt eine gute Abbildung einer Maske (nicht gezeigt) auf die darunterliegende, zu ätzende Schicht des Substrats 26.

Üblicherweise werden als Maskenmaterialien Photolacke verwendet, da diese durch einen Belichtungsschritt und einen Entwicklungsschritt relativ einfach strukturiert werden können.

Der physikalische Teil der Ätzung wird durch Impuls und kinetische Energie der auftreffenden Ionen (z.B. Cl₂ 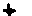 , Ar 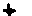 ) bewirkt. Zusätzlich werden dadurch chemische Reaktionen zwischen dem Substrat und den reaktiven Gasteilchen (Ionen, Moleküle, Atome, Radikale) unter Bildung flüchtiger Reaktionsprodukte initiert oder verstärkt (chemischer Teil der Ätzung). Diese chemischen Reaktionen zwischen den Substratteilchen und den Gasteilchen sind verantwortlich für hohe Ätzselektivitäten des Ätzprozesses.

Leider hat sich herausgestellt, daß die oben genannten, in integrierten Schaltungen neu eingesetzten Materialien zu den chemisch nur schwer oder nicht ätzbaren Materialien gehören, bei denen der Ätzabtrag, auch bei der Verwendung 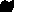 reaktiver" Gase, überwiegend oder fast ausschließlich auf dem physikalischen Anteil der Ätzung beruht.

Wegen der geringen oder fehlenden chemischen Komponente der Ätzung liegt der Ätzabtrag der zu strukturienden Schicht in der selben Größenordnung wie der Ätzabtrag der Maske bzw. der Unterlage (Ätzstoppschicht), d.h. die Ätzselektivität zur Ätzmaske bzw. Unterlage ist im allgemeinen klein (zwischen etwa 0,3 und 3,0). Dies hat zur Folge, daß durch die Erosion von Masken mit geneigten Flanken und die unvermeidliche Facettenbildung der Masken nur eine geringe Maßhaltigkeit der Strukturierung gewährleistet werden kann. Darüber hinaus wird die Unterlage stark angeätzt und es kommt zu schwer kontrollierbaren Abschrägungen der Ätzflanken.

Es ist daher die Aufgabe der vorliegenden Erfindung, ein Strukturierungsverfahren bereitzustellen, das die genannten Nachteile der bisherigen Verfahren vermeidet oder mindert.

Diese Aufgabe wird von dem Verfahren gemäß Patentanspruch 1 gelöst. Weitere vorteilhafte Ausführungsformen, Ausgestaltungen und Aspekte der vorliegenden Erfindung ergeben sich aus den Unteransprüchen der Beschreibung und den beiliegenden Zeichnungen.

Erfindungsgemäß wird ein Verfahren zur Strukturierung zumindest einer zu strukturierenden Schicht bereitgestellt, das die folgenden Schritte umfaßt: die zu strukturierende Schicht wird auf einer Unterlage bereitgestellt, eine Maske wird auf der zu strukturierenden Schicht bereitgestellt, die zu strukturierende Schicht wird trockengeätzt, wobei zumindest ein reaktiver Stoff vorgesehen ist. Das erfindungsgemäße Verfahren ist dadurch gekennzeichnet, daß während der Trockenätzung der reaktive Stoff und das Material der Maske und/oder der Unterlage an der Oberfläche der Maske und/oder der Unterlage zu einer nicht flüchtigen Verbindung reagieren.

Die Erfindung hat den Vorteil, daß während der Trockenätzung die der Ätzung ausgesetzte Oberfläche der Maske und/oder der Unterlage so modifiziert werden, daß der Ätzabtrag der Maske und/oder der Unterlage gesenkt wird. Dies hat zur Folge, daß die Selektivität des Ätzprozesses erhöht wird. Durch die damit verbundene geringere Maskenerosion ergibt sich eine höhere Maßhaltigkeit der Strukturierung. Darüber hinaus lassen sich durch das erfindungsgemäße Verfahren steilere Ätzflanken an der zu strukturienden Schicht erzielen. Ätzflanken mit einem Flankenwinkel von über 85° können erzeugt werden.

Durch eine geeignete Wahl der Stoffmenge des reaktiven Stoffs kann der Flankenwinkel auch gezielt eingestellt werden. Dadurch wird auch eine Einflußnahme auf den Wiederabtrag der Redepositionen ermöglicht, die während des Ätzprozesses an den Ätzflanken abgeschieden werden.

Darüber hinaus kann durch eine andere Wahl des reaktiven Stoffs die Maske bzw. Unterlage, falls erforderlich, wieder leicht entfernt werden.

Bevorzugt ist der reaktive Stoff ein reaktives Gas. Dabei ist es besonders bevorzugt, wenn das reaktive Gas aus einer Gruppe ausgewählt ist, die aus den Gasen Sauerstoff (O₂), Stickstoff (N₂), Wasserstoff (H₂), Fluorverbindungen wie NF₃ oder CF₄, Chlor (Cl₂) oder einer Mischung dieser Gase besteht.

Weiterhin ist bevorzugt, wenn die zu strukturierende Schicht Kupfer, Ferromagnetika, insbesondere Eisen, Kobalt, Nickel oder Permalloy, ein 4d oder 5d Übergangsmetall, insbesondere ein Platinmetall enthält.

Darüberhinaus ist bevorzugt, wenn die zu strukturierende Schicht ein ferroelektrisches Material, ein dielektrisches Material hoher Permittivität (> 20), ein Perowskit oder Vorstufen dieser Materialien enthält. Dabei soll unter einer Vorstufe der genannten Materialien ein Material verstanden werden, das durch eine geeignete Wärmebehandlung (z.B. Tempern), gegebenenfalls unter Zuführung von Sauerstoff, in die genannten Materialien umgewandelt werden kann.

So ist es bevorzugt, wenn die zu strukturierende Schicht Strontiumwismuttantalat (SBT, SrBi₂Ta₂O₉), Strontiumwismuthniobattantalat (SBNT, SrBi₂Ta₂₋ₓNbₓO₉, x=0-2) Bleizirkontitanat (PZT, Pb(Zr,Ti)O₃) oder Derivate sowie Bariumstrontiumtitanat (BST, BaₓSr₁₋ₓTiO₃, x=0-1), Bleilanthantitanat (PLT, (Pb, La)TiO₃), Bleilanthanzirkontitanat (PLZT, (Pb, La)(Zr, Ti)O₃) oder Derivate enthält.

Weiterhin ist es bevorzugt, wenn die zu strukturierende Schicht Platin, Gold, Silber, Iridium, Palladium, Ruthenium, oder deren Oxide enthält.

Vorteilhafterweise enthalten die Maske und/oder die Unterlage ein Metall, insbesondere Aluminium, Titan, Tantal, Molybdän oder Wolfram, ein Metallsilizid, ein Metallnitrid, ein Metalloxid oder Silizium.

Weiterhin ist es bevorzugt, wenn während der Trockenätzung der zu strukturienden Schicht ein Edelgas, insbesondere Argon, vorgesehen ist.

Bevorzugt wird zum Trockenätzen der zu strukturienden Schicht ein Plasmaätzverfahren verwendet.

Die Erfindung wird nachfolgend anhand von Figuren der Zeichnung näher dargestellt. Es zeigen:
Figuren 1 bis 3 eine schematische Darstellung eines erfindungsgemäßen Verfahrens,
Fig. 4 eine schematische Darstellung einer Ätzkammer in Form eines Parallelplattenreaktors.

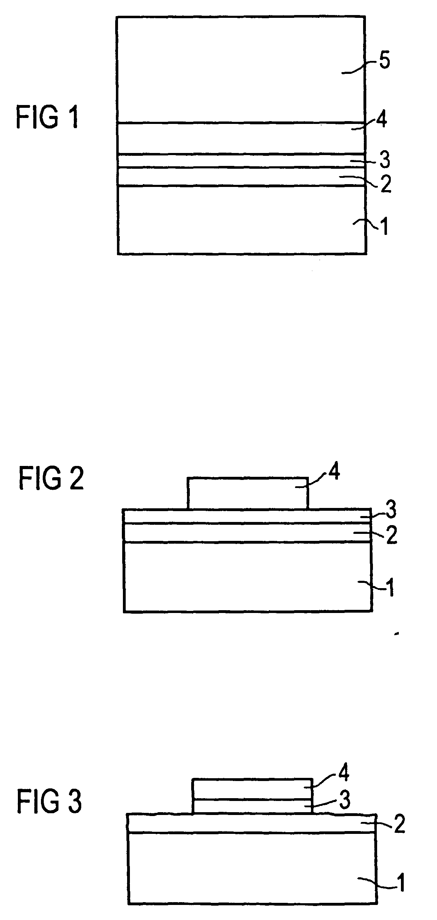

Die Figuren 1 bis 3 zeigen eine schematische Darstellung eines erfindungsgemäßen Verfahrens. Auf einem Siliziumsubstrat 1 wird eine Titanunterlage 2 (Diffusionsbarriere, Ätzstoppschicht) erzeugt. Auf dieser Unterlage 2 wird eine Platinschicht 3 als zu strukturierende Schicht beispielsweise durch Sputtern aufgebracht. Auf der Platinschicht 3 wird eine Aluminiumschicht 4 gebildet. Die Aluminiumschicht 4 kann ebenfalls durch einen Sputterprozess erzeugt werden. Anschließend wird auf die Aluminiumschicht 4 eine Lackschicht 5 aufgebracht. Die sich daraus ergebende Struktur ist in Fig. 1 gezeigt.

Die Aluminiumschicht wird in herkömmlicherweise mit Hilfe der Lackschicht 5 strukturiert, um als Maske für die anschließende Strukturierung der Platinschicht 3 dienen zu können. Die sich daraus ergebende Struktur ist in Fig. 2 gezeigt.

Nachfolgend wird ein reaktives Ionenätzen (RIE, Reactive Ion Etching) durchgeführt, um die Platinschicht 3 einem chemischphysikalischen Trockenätzen zu unterziehen. Als Ätzgas wird dabei Sauerstoff O₂ oder ein Gemisch aus O₂ und weiteren Gasen, z.B. Argon, verwendet. Anstatt des reaktiven Ionenätzens können auch andere Trockenätzverfahren wie beispielsweise das Ionenätzen, das magnetfeldunterstützte reaktive Ionenätzen (MERIE, Magnetically Enhanced RIE), das ECR-Ätzen (ECR,

Electron Cyclotron Resonance) oder induktiv gekoppelte Plasmaätzverfahren (ICP, TCP) eingesetzt werden.

Während des Trockenätzens der Platinschicht 3 werden auf der Oberfläche der Aluminiummaske 4 laufend nicht flüchtige Aluminiumoxid-Oberflächenschichten (Al₂O₃) nachgebildet. Dadurch wird die Ätzrate der Aluminiummaske 4 um einen Faktor zwischen 2 und 8 gesenkt, wodurch sich eine hohe Selektivität (18 bis 45) von der Platinschicht 3 zur Aluminiummaske 4 erzielen läßt.

Ist der Trockenätzprozess soweit fortgeschritten, daß auch die Titanunterlage 2 erreicht wird, so bildet sich auch auf der Oberfläche der Titanunterlage 2 eine nicht flüchtige Titanoxidschicht (TiₓO_{y}), wodurch die Ätzrate der Titanunterlage 2 etwa um eine Größenordnung gesenkt wird. Die sich daraus ergebende Struktur ist in Fig. 3 gezeigt.

Insgesamt wird somit die Selektivität des Ätzprozesses deutlich erhöht. Durch die damit verbundene geringere Maskenerosion ergibt sich eine höhere Maßhaltigkeit der Strukturierung. Durch eine geeignete Wahl der O₂-Konzentration läßt sich der Flankenwinkel der Ätzflanke an der Platinschicht über einen großen Bereich einstellen. Ätzflanken mit einem Flankenwinkel von über 85° können erzeugt werden.

Weiterhin kann bei Grabenätzungen die Bildung nicht flüchtiger Verbindungen an der Oberfläche einer Unterlage (Ätzstoppschicht) dazu verwendet werden, Material aus den unteren Ecken des Grabens nahezu vollständig zu entfernen Bei Grabenätzungen stellt sich häufig das Problem, daß das zu ätzende Material nicht aus den unteren Ecken eines Grabens entfernt werden kann, weil die dafür notwendige Überätzung die Ätzstoppschicht zu stark angreifen wurde. Durch die Bildung nicht flüchtiger Verbindungen an der Oberfläche der Ätzstoppschicht kann jedoch eine längere Überätzung durchgeführt werden, ohne die Ätzstoppschicht zu schädigen. Dementsprechend kann mehr zu ätzendes Material aus den unteren Ecken des Grabens entfernt werden.

Anstatt des beschriebenen Aluminiums können noch weitere Materialien als Masken bzw. Unterlagen verwendet werden. Wird beispielsweise Tantal als Maskenmaterial eingesetzt, so können die durch die Verwendung O₂-haltiger Gasgemische und die damit einhergehende Bildung von Ta₂O₅-Oberflächenschichten die Ätzraten der Ta-Maske um einen Faktor größer als 2 reduziert werden. Wird Silizium als Maskenmaterial eingesetzt, so können die durch die Verwendung O₂- oder N₂-haltiger Gasgemische und die damit einhergehende Bildung von SiO₂- bzw. Si₃N₄-Oberflächenschichten die Ätzraten der Si-Maske ebenfalls um einen Faktor von etwa 2 reduziert werden. Wird Titan als Maskenmaterial eingesetzt, so können die durch die Verwendung N₂-, O₂- oder H₂-haltiger Gasgemische und die damit einhergehende Bildung von Ti₂N-, TiO-, TiO₂- bzw. TiH₂-Oberflächenschichten die Ätzraten der Ta-Maske um einen Faktor 3 reduziert werden.

## Patentansprüche

1. Verfahren zur Strukturierung zumindest einer zu strukturierenden Schicht mit den Schritten:
die zu strukturierende Schicht wird auf einer Unterlage bereitgestellt,
eine Maske wird auf der zu strukturierenden Schicht bereitgestellt,
die zu strukturierende Schicht wird trockengeätzt, wobei zumindest ein reaktiver Stoff vorgesehen ist,
dadurch gekennzeichnet, daß während der Trockenätzung der reaktive Stoff und das Material der Maske und/oder der Unterlage an der Oberfläche der Maske und/oder der Unterlage zu einer nicht flüchtigen Verbindung reagieren.

2. Verfahren nach Anspruch 1, dadurch gekennzeichnet, daß der reaktive Stoff ein reaktives Gas ist.

3. Verfahren nach Anspruch 2, dadurch gekennzeichnet, daß das reaktive Gas aus einer Gruppe ausgewählt ist, die aus den Gasen Sauerstoff (O₂), Stickstoff (N₂), Wasserstoff (H₂), gasförmigen Fluorverbindungen, Chlor (Cl₂) oder einer Mischung dieser Gase besteht.

4. Verfahren nach einem der vorherstehenden Ansprüche, dadurch gekennzeichnet, daß die zu strukturierende Schicht Kupfer, Ferromagnetika, insbesondere Eisen, Kobalt, Nickel oder Permalloy, ein 4d oder 5d Übergangsmetall, insbesondere ein Platinmetall enthält.

5. Verfahren nach einem der vorherstehenden Ansprüche, dadurch gekennzeichnet, daß die zu strukturierende Schicht ein ferroelektrisches Material, ein dielektrisches Material hoher Permittivität, ein Perowskit oder Vorstufen dieser Materialien enthält.

6. Verfahren nach Anspruch 5, dadurch gekennzeichnet, daß die zu strukturierende Schicht Strontiumbismuttantalat (SBT, SrBi₂Ta₂O₉), Strontiumwismuthniobattantalat (SBNT, SrBi₂Ta₂₋ₓ NbₓO₉, x=0-2), Bleizirkontitanat (PZT, Pb(Zr,Ti)O₃) oder Derivate oder paraelektrisches Bariumstrontiumtitanat (BST, BaₓSr₁₋ₓTiO₃, x=0-1), Bleilanthantitanat (PLT, (Pb, La)TiO₃), Bleilanthanzirkontitanat (PLZT, (Pb, La)(Zr, Ti)O₃) oder Derivate enthält.

7. Verfahren nach Anspruch 4, dadurch gekennzeichnet, daß die zu strukturierende Schicht Platin, Gold, Silber, Iridium, Palladium, Ruthenium, oder deren Oxide enthält.

8. Verfahren nach einem der vorherstehenden Ansprüche, dadurch gekennzeichnet, daß die Maske und/oder die Unterlage ein Metall, ein Metallsilizid, ein Metallnitrid, ein Metalloxid oder Silizium enthalten.

9. Verfahren nach Anspruch 8, dadurch gekennzeichnet, daß die Maske und/oder die Unterlage Aluminium, Titan, Tantal, Molybdän oder Wolfram enthalten.

10. Verfahren nach einem der vorherstehenden Ansprüche, dadurch gekennzeichnet, daß während der Trockenätzung der zu strukturienden Schicht ein Edelgas, insbesondere Argon, vorgesehen ist.

11. Verfahren nach einem der vorherstehenden Ansprüche, dadurch gekennzeichnet, daß zum Trockenätzen ein Plasmaätzverfahren verwendet wird.
